Europäisches Patentamt

European Patent Office

Office européen des brevets

(11) Veröffentlichungsnummer : **0 362 478 B1**

(12) **EUROPÄISCHE PATENTSCHRIFT**

(45) Veröffentlichungstag der Patentschrift :
24.05.95 Patentblatt 95/21

(51) Int. Cl.$^6$ : **H03H 9/42,** H03H 3/08

(21) Anmeldenummer : **89111710.3**

(22) Anmeldetag : **27.06.89**

(54) Akustische Verzögerungsleitung.

(30) Priorität : **14.09.88 EP 88115023**

(43) Veröffentlichungstag der Anmeldung :
**11.04.90 Patentblatt 90/15**

(45) Bekanntmachung des Hinweises auf die
Patenterteilung :
**24.05.95 Patentblatt 95/21**

(84) Benannte Vertragsstaaten :
**AT CH DE FR GB LI NL**

(56) Entgegenhaltungen :
**DE-A- 3 027 583**
**GB-A- 1 473 661**
**US-A- 3 906 410**
**US-A- 4 097 825**
**US-A- 4 516 094**

(56) Entgegenhaltungen :
**IEEE 1986 ULTRASONICS SYMPOSIUM PRO-
CEEDINGS, Williamsburg, 17.-19. November
1986, Band 1, Seiten 315-319, IEEE, New York,
US; G. VISINTINI et al.:"Analysis of broadband lamb-wave delay lines"**
**JOURNAL OF APPLIED PHYSICS, Band 44, Nr.
1, Januar 1973, Seiten 56-62, American Institute of Physics, New York, US; K. TODA et al.:
"Lamb-wave delay lines with interdigital electrodes"**

(73) Patentinhaber : **SIEMENS
AKTIENGESELLSCHAFT
Wittelsbacherplatz 2
D-80333 München (DE)**

(72) Erfinder : **Prestele, Karl, Dipl.-Phys.
Bismarckstrasse 21d
D-8520 Erlangen (DE)**
Erfinder : **Soldner, Richard, Dipl.-Ing.
Richard-Wagner-Strasse 7
D-8522 Herzogenaurach (DE)**

EP 0 362 478 B1

## Beschreibung

Die Erfindung betrifft eine akustische Verzögerungsleitung für elektrische Signale, bei der auf einem monolithischen, piezokeramischen Substrat zwei elektroakustische Wandler als Elektrodenstruktur in einem eine Laufzeitstrecke bildenden Abstand zueinander aufgebracht sind, wobei die Elektrodenstrukturen der Wandler deckungsgleich auf beiden Seiten des Substrats aufgebracht sind und die Dicke des Substrats kleiner oder gleich der Wellenlänge der höchsten zu übertragenden Frequenz im Substrat ist.

Die Erfindung betrifft außerdem eine akustische Verzögerungsleitung für elektrische Signale, bei der auf einem monolithischen, piezokeramischen Substrat zwei elektroakustische Wandler als Elektrodenstruktur in einem eine Laufzeitstrecke bildenden Abstand zueinander aufgebracht sind, wobei die Elektrodenstrukturen der Wandler nur auf einer Seite des Substrats aufgebracht sind.

Eine Verzögerungsleitung der erstgenannten Art ist in IEEE Ultrasonics Symposium, 1986, Seiten 315 bis 319, beschrieben. Dort sind auf den beiden Seiten eines piezokeramischen Plättchens symmetrische Elektrodenstrukturen als elektroakustische Wandler aufgebracht. Das piezokeramische Plättchen ist in der Richtung seiner Dicke polarisiert, so daß von den Wandlern symmetrische Lamb-Wellen nullter Ordnung erzeugt werden. Bei großen Signalbandbreiten wirkt sich das dispersive Übertragungsverhalten der Lamb-Wellen negativ aus, d.h. die Schallgeschwindigkeit der Lamb-Wellen ist von der Frequenz abhängig. Außerdem gibt es in jedem Frequenzbereich mehrere Lamb-Moden mit unterschiedlichen Ausbreitungseigenschaften. Die selektive Anregung des Grundmodus erfordert daher ganz bestimmte, engtolerierte Elektrodenstrukturen.

Eine Verzögerungsleitung der zweitgenannten Art ist aus dem Artikel von Kohji Toda: "Lamb-wave delay lines with interdigital electrodes", erschienen in J. App. Phys., Vol. 44, No. 1, Jan. 1973, pp. 56-62, bekannt. Auch bei dieser Verzögerungsleitung werden Lamb-Wellen zur Signalverzögerung benutzt, die die vorgenannten Nachteile aufweisen.

Der Erfindung liegt nun die Aufgabe zugrunde, eine akustische Verzögerungsleitung bereitzustellen, die elektrische Signale im Frequenzbereich von 1 bis 10 MHz breitbandig und mit möglichst geringen Übertragungsverlusten verzerrungsfrei und mit engen Laufzeittoleranzen verzögert. Dabei sollen bei großen Verzögerungswerten die Bauelementeabmessungen klein sein.

Die Aufgabe wird bei der Verzögerungsleitung mit deckungsgleich auf beiden Seiten des Substrats aufgebrachten Elektrodenstrukturen dadurch gelöst, daß das Substrat im wesentlichen senkrecht zu Laufzeitstrecke und Dicke polarisiert ist.

Die Aufgabe wird bei der Verzögerungsleitung mit nur auf einer Seite des Substrats aufgebrachten Elektrodenstrukturen dadurch gelöst, daß die Dicke des Substrats kleiner oder gleich der halben Wellenlänge der höchsten zu übertragenden Frequenz im Substrat ist und daß das Substrat im wesentlichen senkrecht zu Laufzeitstrecke und Dicke polarisiert ist. Durch die angegebene Polarisationsrichtung in Verbindung mit der gewählten Dicke des Substrats entstehen in der Verzögerungsleitung nur Plattenscherwellen im Grundmodus.

Im Vergleich zu Oberflächenwellen-Bauelementen lassen sich Bauelemente mit Plattenscherwellen vorteilhaft auch bei tiefen Frequenzen von z.B. 1 bis 10 MHz einsetzen. Dabei ermöglicht die gute elektromechanische Kopplung von Piezokeramik bei kleiner Einfügedämpfung eine große relative Bandbreite.

Gegenüber den Verzögerungsleitungen für die Zeilenverzögerung bei Pal- und Secam-Dekodern, die mit Volumenwellen und stirnseitig angebrachten Wandlern arbeiten, werden hier Störsignale (Triple-Transit) besser unterdrückt. Außerdem lassen sich Verzögerungsleitungen, die mit Interdigitalwandlern arbeiten, kostengünstiger in großen Stückzahlen herstellen.

Gegenüber rein elektrischen Verzögerungsleitungen treten bei akustischen Verzögerungsleitungen weniger Verzerrungen auf. Außerdem lassen sich mit wenig Aufwand große Verzögerungszeiten und wesentlich kleinere Laufzeittoleranzen realisieren, z.B. ist bei einer Sollaufzeit von 20 μs die Toleranz ± 10 ns oder 0,1 %.

In einer vorteilhaften Ausführungsform sind mehrere Elektrodenstrukturen hintereinander in der Ausbreitungsrichtung der akustischen Wellen auf dem Substrat angeordnet. Diese Elektrodenstrukturen ermöglichen es, auf einer Verzögerungsleitung ein Signal mit verschiedenen Werten zu verzögern.

Eine weitere vorteilhafte Ausführungsform zeichnet sich dadurch aus, daß das Substrat keine zur Wellenfront der akustischen Wellen parallelen Begrenzungen aufweist. Dadurch werden Störsignale auf Grund von Reflexionen an den Substratkanten unterdrückt. Eine andere Maßnahme zur Unterdrückung von Störsignalen (Triple-Transit) ist in einer weiteren Ausführungsform verwirklicht, in der die beiden Wandler nicht parallel zueinander ausgerichtet sind.

Eine weitere vorteilhafte Ausführungsform weist zur Bedämpfung von Störreflexionen einen Absorber außerhalb der Wandler und der Laufzeitstrecke auf dem Substrat auf. Der Absorber kann eine akustische Dämpferschicht oder auch eine elektrische Widerstandsschicht umfassen. Die elektrische Widerstandsschicht wandelt die Energie des elektrischen Feldes, das stets zusammen mit der akustischen Welle auftritt, in Wärmeenergie um.

Zur Vermeidung von kapazitiven Kopplungen zwischen den Wandlern ist in einer weiteren vorteilhaften Ausführungsform eine Masseelektrode zwischen den beiden Wandlern angeordnet.

Zum genauen Laufzeitabgleich ist in einer weiteren Ausführungsform auf der Laufzeitstrecke eine depolarisierte Zone aufgebracht. Die Breite der Zone bestimmt die Laufzeitänderung, da die Schallgeschwindigkeit in der depolarisierten Zone typisch 10 bis 20 % niedriger ist als die Schallgeschwindigkeit im polarisierten Substrat.

Weitere Vorteile ergeben sich aus den Unteransprüchen in Verbindung mit der Figurenbeschreibung. Es zeigen:

Fig. 1 in perspektivischer Ansicht eine Verzögerungsleitung mit einseitiger Wandlerstruktur und mit depolarisierten Zonen,

Fig. 2 in perspektivischer Ansicht eine Verzögerungsleitung mit zweiseitiger Wandlerstruktur und mit depolarisierten Zonen, und

Fig. 3 eine Verzögerungsleitung in Draufsicht mit mehreren Empfangswandlern und einer Masseelektrode.

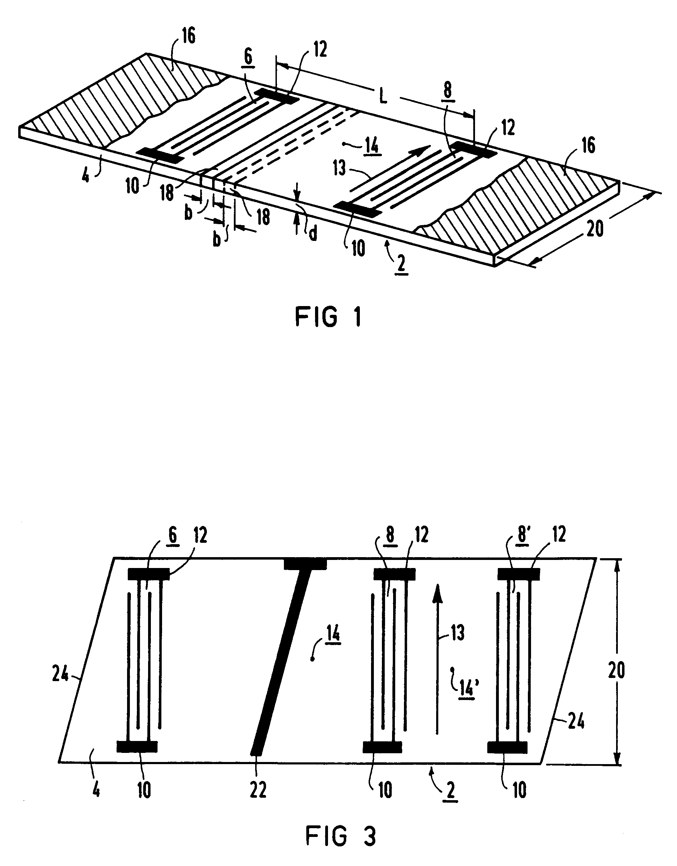

Eine Verzögerungsleitung 2 nach Fig. 1 ist aus einem piezokeramischen Material, wie z.B. Blei-Zirkonat-Titanat (PZT-Keramik) aufgebaut. Auf einem monolithischen Substrat 4 sind im Abstand L zwei elektroakustische Wandler 6 und 8 angeordnet. Die Wandler 6 und 8 werden jeweils durch eine einseitige, interdigitale Elektrodenstruktur aus den Elektroden 10 und 12 zusammen mit dem darunterliegenden Bereich des piezokeramischen Substrats 4 gebildet. Die Elektrodenstrukturen werden vorzugsweise photolithographisch aufgebracht. Die Wandlerstruktur hängt von der Anforderung ab. Je nach geforderter Bandbreite, Einfügedämpfung und Störsignalunterdrückung variiert die Anzahl der Wandlerfinger oder es werden Wandler 6 und 8 mit oder ohne Aperturgewichtung oder sog. Splitfinger verwendet.

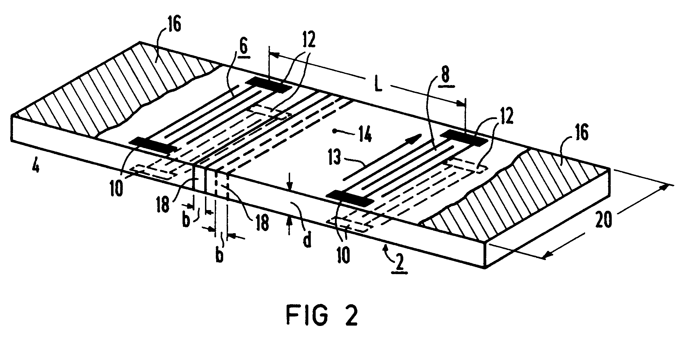

Im Unterschied zur Verzögerungsleitung 2 nach Fig. 1 sind bei der Verzögerungsleitung 2 nach Fig. 2 die Wandler 6 und 8 durch eine zweiseitige deckungsgleiche, interdigitale Elektrodenstruktur mit den Elektroden 10 und 12 zusammen mit dem dazwischenliegenden Bereich des piezokeramischen Substrats 4 gebildet. Die gegenüberliegenden Elektroden 10 und 12 sind jeweils elektrisch miteinander verbunden, so daß die gegenüberliegenden Elektroden 10 und 12 bei Anlegen einer Spannung jeweils das gleiche Potential besitzen.

Die folgenden Ausführungen beziehen sich sowohl auf Fig. 1 als auch auf Fig. 2. Das piezokeramische Substrat 4 ist parallel zu den Fingern der Elektroden 10 und 12 polarisiert. Mit anderen Worten, es ist im wesentlichen parallel zu den Äquipotentiallinien, die bei Anlegen einer Spannung an die Elektrodenstruktur des Wandlers 6 oder 8 im Substrat 4 entstehen, polarisiert. Im wesentlichen parallel heißt hier, daß die Komponente der Polarisation in der Richtung der Äquipotentiallinien überwiegt. Das ist durch einen Pfeil 13 verdeutlicht. Durch diese spezielle Ausrichtung der Polarisation in bezug auf das durch die Elektroden 10 und 12 erzeugte elektrische Feld entsteht im Substrat 4 eine horizontale Plattenscherwelle. Die Dicke des Substrats oder die Plattendicke d ist so dimensioniert, daß im Nutzfrequenzbereich nur horizontal polarisierte Scherwellen nullter Ordnung auftreten können. Um höhere Moden auszuschließen, muß für die Dicke d des piezokeramischen Substrates bei einseitiger Wandlerstruktur nach Fig. 1 die Beziehung

$$d \leqq c_s/2f_g$$

bzw. bei beidseitig deckungsgleicher Wandlerstruktur nach Fig. 2

$$d \leqq c_s/f_g$$

erfüllt sein, wobei $c_s$ die Scherwellengeschwindigkeit und $f_g$ die obere Grenzfrequenz bedeuten. Die Dicke d des piezokeramischen Substrats 4 ist bei einer oberen Grenzfrequenz $f_g$ von 10 MHz etwa 100 bis 200 $\mu$m. Solche Substratplättchen 4 sind sehr zerbrechlich. Zur Verbesserung der Handhabung können sie mit einem ausreichend elastischen Kleber auf einen stabilen Träger geklebt werden (nicht gezeigt), ohne daß die Funktion beeinträchtigt wird.

Der besondere Vorteil der Plattenscherwelle nullter Ordnung zeigt sich darin, daß sie keine Dispersion aufweist, also daß ihre Schallgeschwindigkeit von der Frequenz unabhängig ist. Daher ist eine breitbandige, verzerrungsfreie Verzögerung eines elektrischen Signals möglich.

Der Wandler 6 z.B. erzeugt nach Anlegen eines elektrischen Signals an seinen Elektroden 10 und 12 eine akustische Scherwelle im Substrat 4. Die akustische Welle läuft nun über den Abstand L im Substrat 4 vom Wandler 6 zum Wandler 8. Dieser Bereich des Substrats 4 bildet eine Laufzeit- oder Verzögerungsstrecke 14. Die ebenfalls vom Wandler 6 abgestrahlte Welle in entgegengesetzter Richtung wird durch einen Absorber oder einen akustischen Sumpf 16 absorbiert. Der Wandler 8 wandelt die auftreffende akustische Welle wieder in ein elektrisches Signal um, das zum Signal am Wandler 6 um die Zeit t verzögert ist, entsprechend der Laufzeit der akustischen Welle über den Abstand L. Ein hinter dem Wandler 8 angeordneter weiterer Absorber oder Sumpf 16 dämpft die weiterlaufende akustische Welle. Durch die beiden Sümpfe 16 werden Reflexionen an den Kanten des Substrats 4 (Kantenechos) unterdrückt. Die hier beschriebene Zuordnung des Wandlers 6 als Sendewandler und des Wandlers 8 als Empfangswandler ist willkürlich. Sie ist nur zur Beschreibung der Funktion gewählt. Die Wandler 6, 8 können ebenso umgekehrt als Sende- und Empfangswandler definiert werden.

Der Absorber oder Sumpf 16 besteht aus einer Schicht aus elektrisch leitendem Widerstandsmaterial, dessen Flächenwiderstand so angepaßt ist, daß eine optimale Dämpfung des stets mit der akustischen Welle auftretenden elektrischen Feldes erfolgt.

Zusätzlich oder alternativ kann mit einem akustischen Absorber bedämpft werden. Geeignete mechanische Dämpfungsmassen werden dazu im Gießverfahren oder auch per Siebdruck auf die Oberfläche des Substrats 4 aufgebracht.

Da die Ausbreitungsgeschwindigkeit von akustischen Wellen in piezokeramischem Material wesentlich geringer ist als die Ausbreitungsgeschwindigkeit von elektromagnetischen Wellen, wird durch den Abstand L der beiden Wandler 6 und 8 eine entsprechend lange Verzögerung eines elektrischen Signals bei kleinen Bauelementeabmessungen erreicht. Insbesondere ist Scherwellengeschwindigkeit nur etwa halb so groß wie die Lamb-Wellengeschwindigkeit. Daher werden auch bei langen Verzögerungszeiten die Bauelementeabmessungen klein. Eine Verzögerungsleitung mit einer Verzögerungszeit von z.B. 20 μs hat eine Länge von ca. 50 mm.

Parallel zur Schallausbreitungsfront ist auf der Verzögerungsstrecke 14 eine säulenförmige depolarisierte Zone 18 geschaffen. Die Zone erstreckt sich über die gesamte Breite 20 des Substrates 4 oder des Bauteils.

Diese Zone 18 dient dem genauen Abgleich der Laufzeit t. Da die Laufzeit t durch die depolarisierte Zone 18 nur verlängert werden kann, muß bei der Dimensionierung der Laufzeitstrecke 14 der erforderliche Korrekturspielraum durch eine entsprechende Verkürzung von L bereitgestellt werden. Die genaue Einstellung der geforderten Verzögerungszeit t erfolgt durch Aneinanderreihen von depolarisierten Zonen 18, wie es in der FIG 1 gestrichelt angedeutet ist. Mit Hilfe des Abgleichs lassen sich hochgenaue Verzögerungsleitungen mit einer Toleranz von z.B. 0,1 % herstellen.

Eine Verzögerungsleitung mit einseitiger Wandlerstruktur, bei der Signale mit verschiedenen Verzögerungszeiten abgegriffen werden können, zeigt Fig. 3. Die Bezugszeichen sind gleich gewählt wie in Fig. 1. Zusätzlich zu der in Fig. 1 gezeigten Ausführungsform befindet sich in Schallausbreitungsrichtung hinter dem Wandler 8 ein weiterer Wandler 8′. Die Gesamtlaufzeitstrecke zwischen dem Wandler 6 und dem Wandler 8′ umfaßt nun die Teillaufstrecke 14 und die Teillaufstrecke 14′. Es ist möglich, weitere Wandler 6, 8 oder 8′ in der Schallausbreitungsrichtung auf dem Substrat anzuordnen (hier nicht gezeigt), um mehrere Signale mit verschiedenen Verzögerungen abgreifen zu können.

Auf dem Substrat 4 befindet sich zwischen den Wandlern 6 und 8 auf der Laufzeitstrecke 14 eine Masseelektrode 22. Sie verhindert eine kapazitive Kopplung zwischen den Wandlern 6 und 8. Die Entkopplungswirkung der Masseelektrode 22 kann verstärkt werden, wenn ein mit der Masseelektrode 22 verbundenes leitfähiges Gehäuse (nicht gezeigt) dicht an den Wandlern 6, 8, 8′ und der Laufzeitsstrecke 14 angeordnet ist.

Durch eine schräge Ausrichtung bezüglich der Schallwellenfront und des Wandlers 8 werden störende Reflexionen zwischen dem Wandler 8 und der Masseelektrode 22 weitgehend vermieden. Reflexionen (Mehrfachechos) an der Masseelektrode 22 treffen nun nicht mehr gleichphasig, sondern mit unterschiedlichen Phasenlagen auf dem Empfangswandler 8 auf, so daß die resultierende Amplitude des elektrischen Störsignals nahezu verschwindet.

Falls die Masseelektrode 22 nicht direkt auf dem Substrat 4, sondern in einem geringen Abstand (nicht gezeigt) zwischen den Wandlern 6 und 8 angeordnet ist, wird die Schallausbreitung auf der Laufzeitstrecke 14 nicht beeinflußt. Daher kann die Masseelektrode 22, in diesem Fall ohne den Verlauf der Schallwellenfront zu berücksichten, ausgerichtet werden.

Der Unterdrückung von Störsignalen dient ebenfalls die Abschrägung der Querkanten 24 des Substrats 4. Auch hier trifft nach Reflexion die akustische Welle nicht mehr gleichphasig auf die Wandler 6, 8 und 8′ auf, sondern in unterschiedlichen Phasenlagen. Auch damit werden störende Signale aufgrund von Reflexionen an den Kanten (Kantenechos) nahezu vermieden.

Eine weitere Möglichkeit, Störsignale (Triple-Transit) zwischen dem Sendewandler 6 und dem Empfangswandler 8 zu unterdrücken, besteht darin, den Empfangswandler 8 schräg zur Schallausbreitungsfront auszurichten (hier nicht gezeigt). Auch durch diese Maßnahme treten, ebenso wie bei der schrägen Ausrichtung der Masseelektrode 22 und der Querkante 24, die reflektierten Schallwellen nicht mehr gleichphasig an den Elektroden auf, sondern heben sich bis auf eine nicht mehr störende, kleine Amplitude gegenseitig auf.

Akustische Verzögerungsleitungen für den Frequenzbereich von 1 bis 10 MHz und mit Verzögerungszeiten bis zu 20 μs finden Anwendung in Ultraschall-Diagnostiksystemen zur Untersuchung von Körpergewebe. Dort ist jeweils eine Verzögerungsleitung einem oder mehreren Einzeltransducern eines Transducer-Arrays zugeordnet. Mit Hilfe der Verzögerungsleitungen werden die abgestrahlten Ultraschallsignale und die empfangenen Echosignale so verzögert, daß der Ultraschallstrahl auf eine bestimmte Tiefe fokussiert wird (Linearabtastung). Zusätzlich kann eine Schwenkung des Ultraschallsignals erfolgen, so daß ein sektorförmiger Bereich abgetastet wird. Damit im Ultraschallbild keine Helligkeitssprünge aufgrund der eingefügten Verzögerung sichtbar sind, kann die laufzeitabhängige Dämpfung des piezokeramischen Substrats 4 durch geeignete Materialzusammensetzung oder Oberflächenbeschichtung auf der Laufzeitstrecke 14 und 14' so ausgewählt bzw. eingestellt werden, daß sie der Dämpfung des Ultraschallstrahls im Körpergewebe entspricht. So ist bei gleicher Laufzeit die Absorption der akustischen Welle auf der Laufzeitstrecke 14 gleich der Absorption des Ultraschallsignals im Körpergewebe.

**Patentansprüche**

1. Akustische Verzögerungsleitung (2) für elektrische Signale, bei der auf einem monolithischen, piezokeramischen Substrat (4) zwei elektroakustische Wandler (6,8,8') als Elektrodenstuktur in einem eine Laufzeitstrecke bildenden Abstand (L) zueinander aufgebracht sind, wobei die Elektrodenstrukturen der Wandler (6,8,8') deckungsgleich auf beiden Seiten des Substrats (4) aufgebracht sind und die Dicke (d) des Substrats (4) kleiner oder gleich der Wellenlänge der höchsten zu übertragenden Frequenz im Substrat (4) ist, **dadurch gekennzeichnet**, daß das Substrat (4) im wesentlichen senkrecht zu Laufzeitstrecke (L) und Dicke (d) polarisiert ist.

2. Akustische Verzögerungsleitung (2) für elektrische Signale, bei der auf einem monolithischen, piezokeramischen Substrat (4) zwei elektroakustische Wandler (6,8,8') als Elektrodenstruktur in einem eine Laufzeitstrecke bildenden Abstand (L) zueinander aufgebracht sind, wobei die Elektrodenstrukturen der Wandler (6,8,8') nur auf einer Seite des Substrats (4) aufgebracht sind, **dadurch gekennzeichnet**, daß die Dicke (d) des Substrats (4) kleiner oder gleich der halben Wellenlänge der höchsten zu übertragenden Frequenz im Substrat (4) ist und daß das Substrat (4) im wesentlichen senkrecht zu Laufzeitstrecke (L) und Dicke (d) polarisiert ist.

3. Akustische Verzögerungsleitung nach einem der Ansprüche 1 oder 2, **dadurch gekennzeichnet**, daß die Elektrodenstruktur als interdigitale Struktur auf dem Substrat (4) aufgebracht ist.

4. Akustische Verzögerungsleitung nach einem der Ansprüche 1 bis 3, **dadurch gekennzeichnet**, daß mehrere Wandler (8, 8') auf der Laufzeitstrecke (14) angeordnet sind.

5. Akustische Verzögerungsleitung nach einem der Ansprüche 1 bis 4, **dadurch gekennzeichnet**, daß das Substrat (4) keine zur Wellenfront der akustischen Wellen parallelen Begrenzungen aufweist.

6. Akustische Verzögerungsleitung nach einem der Ansprüche 1 bis 5, **dadurch gekennzeichnet**, daß die Wandler (6, 8, 8') nicht parallel zueinander ausgerichtet sind.

7. Akustische Verzögerungsleitung nach einem der Ansprüche 1 bis 6, **dadurch gekennzeichnet**, daß zur Bedämpfung von Störreflexionen ein Absorber (16) außerhalb der Wandler und der Laufzeitstrecke (14) auf dem Substrat (4) aufgebracht ist.

8. Akustische Verzögerungsleitung nach einem der Ansprüche 1 bis 7, **dadurch gekennzeichnet**, daß der Absorber (16) eine akustische Dämpferschicht umfaßt.

9. Akustische Verzögerungsleitung nach einem der Ansprüche 1 bis 8, **dadurch gekennzeichnet**, daß der Absorber (16) eine elektrische Widerstandsschicht mit angepaßter elektrischer Leitfähigkeit umfaßt.

10. Akustische Verzögerungsleitung nach einem der Ansprüche 1 bis 9, **dadurch gekennzeichnet**, daß eine Masseelektrode (22) zwischen dem Sendewandler (6) und dem Empfangswandler (8, 8') angeordnet ist.

11. Akustische Verzögerungsleitung nach Anspruch 10, **dadurch gekennzeichnet**, daß die Masseelektrode (22) nicht parallel zu dem Empfangswandler (8, 8') ausgerichtet ist.

12. Akustische Verzögerungsleitung nach Anspruch 10 oder 11, **dadurch gekennzeichnet**, daß die Masseelektrode (22) sich unmittelbar auf dem Substrat (4) befindet.

13. Akustische Verzögerungsleitung nach Anspruch 10 oder 11, **dadurch gekennzeichnet**, daß die Masseelektrode (22) in einem Abstand zum Substrat (4) angeordnet ist.

**14.** Akustische Verzögerungsleitung nach einem der Ansprüche 1 bis 13, **dadurch gekennzeichnet**, daß die Laufzeitstrecke (14, 14′) eine depolarisierte Zone (18) aufweist.

**15.** Akustische Verzögerungsleitung nach einem der Ansprüche 1 bis 14, **dadurch gekennzeichnet**, daß in einem Ultraschall-Diagnostiksystem zur Untersuchung von Körpergewebe jeweils eine Verzögerungsleitung (2) einem oder mehreren Einzeltransducern eines Transducer-Arrays zugeordnet ist zum verzögerten Abstrahlen von Ultraschallsignalen und/oder zum verzögerten Empfangen von Echosignalen, wobei die Verzögerungen eine Fokussierung und/oder Schwenkung des Ultraschallsignales bewirken.

**16.** Akustische Verzögerungsleitung nach Anspruch 15, **dadurch gekennzeichnet**, daß auf dem Substrat (4) auf der Laufzeitstrecke (14, 14′) bei gleicher Laufzeit die Absorption der akustischen Welle auf der Laufzeitstrecke (14, 14′) der Absorption des Ultraschallsignals im Körpergewebe entspricht.

**17.** Akustische Verzögerungsleitung nach Anspruch 16, **dadurch gekennzeichnet**, daß die gewünschte Absorption durch die Materialzusammensetzung des Substrats (4) erreicht wird.

**18.** Akustische Verzögerungsleitung nach Anspruch 16, **dadurch gekennzeichnet**, daß die gewünschte Absorption durch eine Beschichtung auf der Laufzeitstrecke (14) erreicht wird.

## Claims

**1.** Acoustic delay line (2) for electric signals, wherein two electro-acoustical transducers (6,8,8′) as electrode structure are applied to a monolithic, piezoceramic substrate (4) at a distance (L) from one another which forms a transition time stretch, whereby the electrode structures of the transducers (6,8,8′) are applied in coincidence on both sides of the substrate (4) and the thickness (d) of the substrate (4) is less than or equal to the wavelength of the highest frequency to be transmitted in the substrate (4), characterized in that the substrate (4) is polarized substantially perpendicularly to the transition time stretch (L) and thickness (d).

**2.** Acoustic delay line (2) for electric signals, wherein two electro-acoustical transducers (6,8,8′) as electrode structure are applied to a monolithic, piezoceramic substrate (4) at a distance (L) from one another which forms a transition time stretch, whereby the electrode structures of the transducers (6,8,8′) are only applied to one side of the substrate (4), characterized in that the thickness (d) of the substrate (4) is less than or equal to half the wavelength of the highest frequency to be transmitted in the substrate (4) and in that the substrate (4) is polarized substantially perpendicularly to the transition time stretch (L) and thickness (d).

**3.** Acoustic delay line according to one of claims 1 or 2, characterized in that the electrode structure is applied to the substrate (4) as inter-digital structure.

**4.** Acoustic delay line according to one of claims 1 to 3, characterized in that several transducers (8, 8′) are arranged on the transition time stretch (14).

**5.** Acoustic delay line according to one of claims 1 to 4, characterized in that the substrate (4) does not have any limitations in parallel with the wave front of the acoustic waves.

**6.** Acoustic delay line according to one of claims 1 to 5, characterized in that the transducers (6,8,8′) are not aligned in parallel with one another.

**7.** Acoustic delay line according to one of claims 1 to 6, characterized in that to attenuate interference reflections an absorber (16) outside the transducers and the transition time stretch (14) is applied to the substrate (4).

**8.** Acoustic delay line according to one of claims 1 to 7, characterized in that the absorber (16) comprises an acoustic attenuating layer.

**9.** Acoustic delay line according to one of claims 1 to 8, characterized in that the absorber (16) comprises an electric resistance layer with adapted electroconductivity.

10. Acoustic delay line according to one of claims 1 to 9, characterized in that an earth electrode (22) is arranged between the transmitting transducer (6) and the receiving transducer (8, 8′).

11. Acoustic delay line according to claim 10, characterized in that the earth electrode (22) is not aligned in parallel with the receiving transducer (8, 8′).

12. Acoustic delay line according to claim 10 or 11, characterized in that the earth electrode (22) is located directly on the substrate (4).

13. Acoustic delay line according to claim 10 or 11, characterized in that the earth electrode (22) is arranged with clearance from the substrate (4).

14. Acoustic delay line according to one of claims 1 to 13, characterized in that the transition time stretch (14, 14′) has a depolarized zone (18).

15. Acoustic delay line according to one of claims 1 to 14, characterized in that in an ultrasonic diagnostics system, to examine body tissue in each case a delay line (2) is associated with one or more single transducers of a transducer array for the delayed radiation of ultrasonic signals and/or for the delayed reception of echo signals, whereby the delays effect a focusing and/or oscillation of the ultrasonic signal.

16. Acoustic delay line according to claim 15, characterized in that on the substrate (4) on the transition time stretch (14, 14′) with the same transition time the absorption of the acoustic wave on the transition time stretch (14, 14′) corresponds to the absorption of the ultrasonic signal in the body tissue.

17. Acoustic delay line according to claim 16, characterized in that the desired absorption is achieved by the material composition of the substrate (4).

18. Acoustic delay line according to claim 16, characterized in that the desired absorption is achieved by a coating on the transition time stretch (14).

**Revendications**

1. Ligne à retard acoustique (2) pour des signaux électriques, dans laquelle deux transducteurs électroacoustiques (6,8,8′) sont déposés en tant que structures à électrodes à une distance mutuelle (L) représentant une section de temps de propagation sur un substrat piézocéramique monolithique (4), les structures à électrodes des transducteurs (6,8,8′) étant disposées en coïncidence sur les deux faces du substrat (4) et l'épaisseur (d) du substrat (4) étant inférieure ou égale à la longueur d'onde de la fréquence maximale à transmettre dans le substrat (4), caractérisée par le fait que le substrat (4) est polarisé essentiellement perpendiculairement à la section de temps de propagation (L) et à l'épaisseur (d).

2. Ligne à retard acoustique (2) pour des signaux électriques, dans laquelle deux transducteurs électroacoustiques (6,8,8′) sont déposés en tant que structures à électrodes à une distance mutuelle (L) représentant une section de temps de propagation sur un substrat piézocéramique monolithique (4), les structures à électrodes des transducteurs (6,8,8′) n'étant déposées que sur l'une des deux faces du substrat (4), caractérisée par le fait que l'épaisseur (d) du substrat (4) est inférieure ou égale à la demi-longueur d'onde correspondant à la fréquence la plus grande à transmettre dans le substrat (4) et par le fait que le substrat (4) est polarisé essentiellement perpendiculairement à la section de temps de propagation (L) et à l'épaisseur (d).

3. Ligne à retard acoustique suivant l'une des revendications 1 ou 2, caractérisée par le fait que la structure à électrodes est déposée sous la forme d'une structure interdigitée sur le substrat (4).

4. Ligne à retard acoustique suivant l'une des revendications 1 à 3, caractérisée par le fait que plusieurs transducteurs (8,8′) sont disposés dans la section de temps de propagation (14).

5. Ligne à retard acoustique suivant l'une des revendications 1 à 4, caractérisée par le fait que le substrat (4) ne possède aucune limite parallèle au front d'onde des ondes acoustiques.

6. Ligne à retard acoustique suivant l'une des revendications 1 à 5, caractérisée par le fait que les transducteurs (6,8,8′) ne sont pas orientés parallèlement l'un à l'autre.

7. Ligne à retard acoustique suivant l'une des revendications 1 à 6, caractérisée par le fait que pour atténuer des réflexions parasites, un absorbeur (16) est déposé à l'extérieur des transducteurs et de la section de temps de propagation (14) sur le substrat (4).

8. Ligne à retard acoustique suivant l'une des revendications 1 à 7, caractérisée par le fait que l'absorbeur (16) comprend une couche d'atténuation acoustique.

9. Ligne à retard acoustique suivant l'une des revendications 1 à 8, caractérisée par le fait que l'absorbeur (16) comprend une couche résistive diélectrique de conductivité électrique adaptée.

10. Ligne à retard acoustique suivant l'une des revendications 1 à 9, caractérisée par le fait qu'une électrode de masse (22) est disposée entre le transducteur d'émission (6) et le transducteur de réception (8,8′).

11. Ligne à retard acoustique suivant la revendication 10, caractérisée par le fait que l'électrode de masse (22) n'est pas orientée parallèlement au transducteur de réception (8,8′).

12. Ligne à retard acoustique suivant la revendication 10 ou 11, caractérisée par le fait que l'électrode de masse (22) se trouve directement sur le substrat (4).

13. Ligne à retard acoustique suivant la revendication 10 ou 11, caractérisée par le fait que l'électrode de masse (22) est à une certaine distance du substrat (4).

14. Ligne à retard acoustique suivant l'une des revendications 1 à 13, caractérisée par le fait que la section de temps de propagation (14,14′) comporte une zone dépolarisée (18).

15. Ligne à retard acoustique suivant l'une des revendications 1 à 14, caractérisée par le fait que dans un système de diagnostic à ultrasons, pour l'examen d'un tissu corporel, une ligne à retard (2) est associée à un ou plusieurs transducteurs individuels d'un réseau de transducteurs, pour l'émission retardée de signaux ultrasonores et/ou pour la réception retardée de signaux d'échos, les retards provoquant une focalisation et/ou un pivotement du signal ultrasonore.

16. Ligne à retard acoustique suivant la revendication 15, caractérisée par le fait que dans la section de temps de propagation (14,14′) sur le substrat (4), pour un même temps de propagation, l'absorption de l'onde acoustique dans la section de temps de propagation (14,14′) correspond à l'absorption du signal ultrasonore dans le tissu corporel.

17. Ligne à retard acoustique suivant la revendication 16, caractérisée par le fait que l'absorption souhaitée est obtenue par la composition du matériau du substrat (4).

18. Ligne à retard acoustique suivant la revendication 16, caractérisée par le fait que l'absorption souhaitée est obtenue par un revêtement déposé sur la section de temps de propagation (14).

FIG 1

FIG 3

FIG 2